# EUROPEAN PATENT SPECIFICATION

(11) **EP 0 199 300 B1**
(45) Date of publication and mention of the grant of the patent: **30.06.1993**
(21) Application number: 86105370.0
(22) Date of filing: 18.04.1986
(51) Int. Cl.: H01L 21/312

(54) **Method for making a patterned metal layer**
Verfahren zum Herstellen eines Musters in einer Metallschicht
Procédé de fabrication d'un dessin dans une couche métallique

(30) Priority: 19.04.1985 JP 84913/85
(43) Date of publication of application: 29.10.1986
(73) Proprietor: Matsushita Electronics Corporation, Kadoma-shi, Osaka 571 (JP)
(72) Inventor: Kanazawa, Kunihiko, Toyonaka City, 560 (JP); Kazumura, Masaru, Takatsuki City, 569 (JP)
(74) Representative: Dr. Elisabeth Jung Dr. Jürgen Schirdewahn Dipl.-Ing. Claus Gernhardt

(56) References cited:
- EP-A- 0 098 318
- EP-A- 0 102 281
- US-A- 4 029 562
- US-A- 4 362 598
- US-A- 4 498 952

## Description

### FIELD OF THE INVENTION AND RELATED ART STATEMENT

### 1. FIELD OF THE INVENTION

The present invention is related to a method for making a patterned metal layer and particularly related to a method for making a low resistance metal wiring.

### 2. DESCRIPTION OF THE RELATED ART

Recently, technology to make semiconductor device for high frequency and high speed is developed. The GaAs-FET is given attention to as an FET having excellent high frequency characteristics. Particularly, a GaAs-MES-FET integrated circuit is developed aiming multi-functions, high stability and high gain. However, further development of such highly integrated device that the noise characteristics is superior under 10 GHz or more high frequency is strongly required, responding to the beginning of the satellite broadcasting.

Now, the reduction of the wiring resistance is a necessary condition to obtain such low noise and high integration.

For instance, in a GaAs monolithic microwave integrated circuit (GaAs MMIC), the reduction of the wiring resistance is designed as mentioned below.

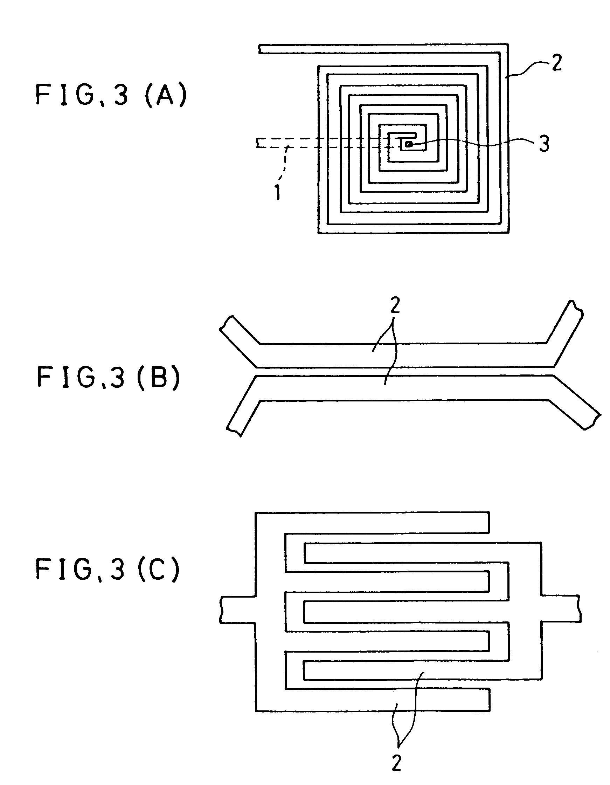

A spiral inductance as shown in FIG.3(A), a coupler as shown in FIG.3(B) and an interdigital capacitor (a comb type capacitor) as shown in FIG.3(C) are fundamental elements of the GaAs MMIC. A hole 3 is contact window. For the spiral inductance and the interdigital capacitor, the narrower the line width of the wiring 2 and the space between lines of the wiring 2 are, the larger the inductance or the capacitance is. Thereby, the production of the elements becomes possible in a small area. A wiring 1 is provided on another layer not indicated herein. However, the narrower the line width and the space between lines are, the larger the wiring resistance is and the more inferior the noise characteristic is and further the lower the gain is and still further the more inferior the high frequency characteristic is.

Therefore, plating on the wiring is executed to make the thickness of the wiring large, hence, to reduce the wiring resistance. And, 2 to 3 µm thick plating on the wiring 2 is executed by using a 2 to 3 µm thick resist as a mask.

However, the conventional art could not make precise plating pattern on the wiring by using a thick photoresist film. That is, in the conventional making of thick phostoresist, the mask of the resist is formed by light exposure and subsequent development, and therefore, the vertical cross sectional shape of the mask of the photoresist becomes a trapezoid configuration in which an upper side is narrower than a lower side. Therefore, when the plating is executed by using the above-mentioned mask, the shape of the plated metal layer becomes such trapezoid configuration that the upper side is wider than the lower side. Accordingly, the space configuration between the plated metal layers neighboring becomes such trapezoid configuration that the upper side is narrower than the lower side. Therefore, the required precise dimensions of the wiring plating is not obtainable. Particularly, when the line width or the space between the lines is in the order of 2 to 3 µm or less. Therefore the conventional method has such problem that accurate high frequency inductance, capacitance, or coupler is not obtainable.

There is, moreover, known from US-A-4 362 598 a method for producing high resolution pattern in a thick layer of polymeric plastic resist which method comprises forming an organic resist layer on a substrate, forming an inorganic layer on said resist layer, selectively removing said inorganic layer thereby retaining a predetermined pattern, and selectively dry-etching said resist layer by using said inorganic layer of the predetermined pattern as a mask thereby to make a second mask of said organic resist material. Said mask is utilized to perform other operations on the substrate, for example there is performed a reactive ion etching step to edge a pattern in the substrate.

There is also known from EP-A-0 102 281 a method for making a patterned metal layer comprising the steps of forming a resist layer made of an organic material on a substrate, forming an inorganic film on said resist layer, selectively removing said inorganic film thereby retaining a predetermined pattern, selectively dry-etching said resist layer by using said inorganic film of said predetermined pattern as a first mask thereby to make a second mask having the side walls substantially perpendicular to the substrate, and forming a metal layer by deposition (evaporation) of said metal on the exposed portions of the substrate and the inorganic film of said predetermined pattern. The metal may be wiring metal. If the exposed portions of the substrate to which the wiring metal is to be deposited are narrow and the lines along which the wiring metal is to be deposited is relative deep so that deep gaps are to be filled, it becomes difficult to deposit the wiring metal within such gaps. At the beginning of deposition both the surface of the inorganic film and the exposed portions of the substrate are covered with the wiring metal. As the deposited metal on the surface of the inorganic film becomes large the deposited metal grows not only vertically but also transversally and, at last, deposited metal bridges the said gaps. As a consequence the wiring metal never fills the whole gap as it is originally desired. Therefore, the wiring metal layer cannot be formed completely.

The present invention intends to offer a method for making a patternd metal layer to resolve the above-mentioned problems of the conventional methods.

Accordingly, the present invention provides for a method for making a patterned metal layer comprising the steps of:
forming a conductive film on a substrate,
forming a resist layer made of an organic material on said conductive film,
forming an inorganic film on said resist layer,
selectively removing said inorganic film thereby retaining a predetermined pattern,
selectively dry-etching said resist layer by using said inorganic film of said predetermined pattern as a first mask thereby to make a second mask having the side walls perpendicular to the substrate and the conductive film, and
forming a metal layer with using said second mask of said patterned resist layer by an electrolytic plating method in which said conductive film is used as one electrode.

The conductive film used in the present invention has two important functions, i.e. it acts as a protective layer for the substrate during dry-etching and as an electrode during the electrolytic plating of the wiring metal layer.

### BRIEF DESCRIPTION OF THE DRAWINGS

FIG.1 is a cross sectional view showing a semiconductor in a certain step of the method for making a patterned metal layer of the present invention.

FIG.2(A), FIG.2(B), FIG.2(C), FIG.2(D) and FIG.2(E) are cross-sectional views showing a flow of process of an embodiment of the method for making a patterned metal layer of the present invention.

FIG.3(A) is the plan view showing the wiring of the conventional spiral inductance.

FIG.3(B) is the plan view showing the wiring of the conventional coupler.

FIG.3(C) is the plan view showing the wiring of the conventional interdigital capacitor.

### DESCRIPTION OF THE PREFERRED EMBODIMENTS

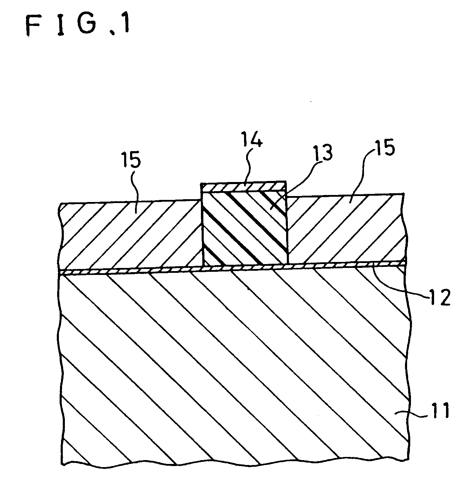

One embodiment of the present invention is described as follows referring to FIG.1, FIG.2 and FIG.3.

FIG.1 is the cross-sectional view showing the semiconductor in a certain step of the method for making the patterned metal layer of the present invention.

In FIG.1, a thin conductive film 12, for instance, a metal film such as Ni or Au or laminated layer of Cr (lower) and Au (upper) is formed on a semiconductor substrate or an insulation substrate 11. A photoresist layer 13 made of organic material, for example, photoresist, is formed on a part of the surface of the contuctive film 12. A thin inorganic film 14 is formed on the photoresist layer 13. A plated metal layer 15 is formed on a remaining part of the surface of the conductive film 12. The side wall of the photoresist layer 13 is perpendicular to the semiconductor substrate 11 and the conductive film 12. Therefore, the wiring, particularly, the plated metal layer 15 is formed with its side wall perpendicular against the semiconductor substrate 11 and the conductive film 12.

The process steps of the method of the present invention is mentioned below.

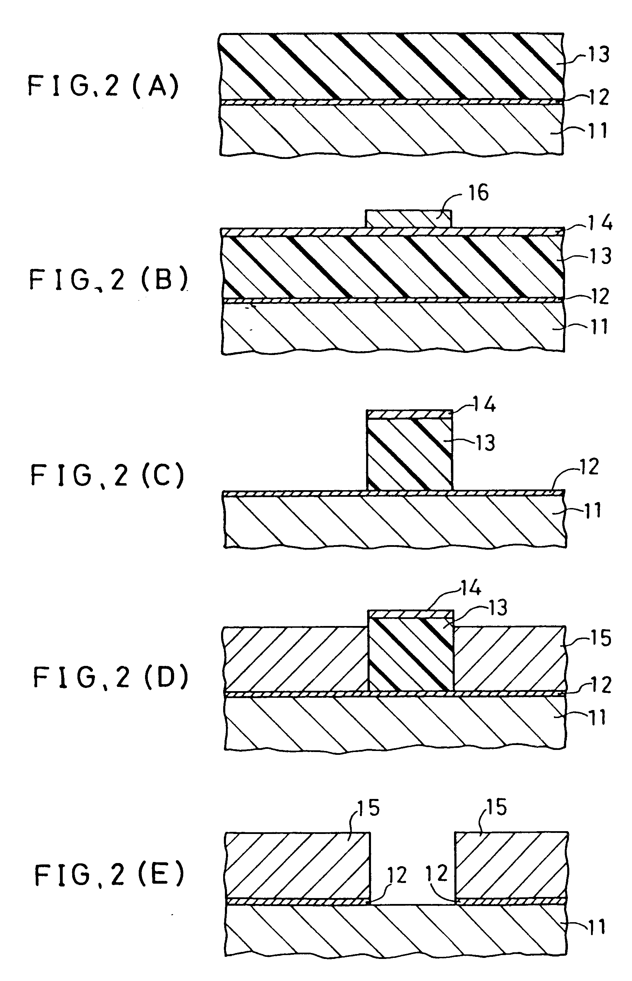

First, the photoresist layer 13 of 3 to 5 µm thick is coated on the whole surface of the conductive film 12 of 0,05 to 0,1 µm (500 to 1000 Å) thick on the semiconductor substrate 11 as shown in FIG.2(A).

The inorganic film 14 is formed by 0,1 to 0,2 µm (1000 to 2000 Å) thickness with coating SiO₂ substance or evaporating aluminium or gold on the resist layer 13 as shown in FIG.2(B).

A conventional thin photoresist layer 16 of about 1 µm thickness for fine pattern is coated on the inorganic film 14. Further, the conventional thin photoresist layer 16 is exposed and developed, thereby to form a required patterned thin photoresist layer 16. This patterned thin photoresist layer 16 has perpendicular side wall, since the thickness is so small, even though using the exposure and development. Such patterned thin photoresist layer 16 can be formed with an accuracy of within an error of only 0.1 µm or less.

The inorganic film 14 is etched by chemical etching method (wet etching method) or dry etching method with using the patterned thin photoresist layer 16.

The patterned photoresist layer 13 is etched by a dry ethcing method, for instance, a reactive ion etching (RIE) method with using the inorganic film 14 as a mask. As a result of such dry etching method, the side wall of the organic material photoresist layer 13 can be made perpendicular against the semiconductor substrate 11 and the conductive film 12, and thus a mask having the perpendicular side wall is made. The mask is superior for controlling the forming of the wiring metal layer and so on.

The wiring metal layer 15 is formed by an electrolytic plating method, with the perpendicular side wall mask of the resist layer 13 and the inorganic film 14.

Utilizing the plating method for forming the thick wiring metal layer 15, the 2 to 4 µm thick wiring metal layer can be formed, as shown in FIG.2(D), only on the conductive film 12 but not on either the inorganic film 14 or the side wall of the photoresist layer 13. As the plating method, an electrolytic plating method is used. This electrolytic plating method uses the conductive film 12 as one electrode, to form the wiring metal layer 15 uniformly on the surface except under the resist layer 13, of the conductive film 12. The thickness of the wiring metal layer 15 can be formed extremely precisely by controlling the voltage or the current and time in the electrolytic plating method.

Gold plating as the metal plating is used when the wiring metal resistance should be very small.

After forming the wiring metal layer, the photoresist layer 13 and the inorganic layer 14 are removed by using known lift off method, and so on.

Finally, the lowest exposed conductive film 12 is removed by etching as shown in FIG.2(E), thereby to complete the 2 to 4 µm thick wiring metal layer pattern of within 0.2 to 0.3 µm error. When the pressure of the chamber in the reactive ion etching process is precisely controlled, the error can be within 0.1 to 0.2 µm. A selectively etching liquid is preferable to be used for the above last etching.

According to the above-mentioned method, the wiring layer of the spiral inductance as shown in FIG.3(A), the wiring layer of the coupler as shown in FIG.3(B) or the wiring layer of the interdigital capacitor as shown in FIG.3(C) can be made with desirable low resistance, and 2 to 4 µm thick wiring metal can be made with at most 0.1 to 0.2 µm error.

## Claims

1. Method for making a patterned metal layer comprising the steps of:
forming a conductive film (12) on a substrate (11),
forming a resist layer (13) made of an organic material on said conductive film (12),
forming an inorganic film (14) on said resist layer (13),
selectively removing said inorganic film (14) thereby retaining a predetermined pattern,
selectively dry-etching said resist layer (13) by using said inorganic film (14) of said predetermined pattern as a first mask thereby to make a second mask having side walls perpendicular to the substrate (11) and the conductive film (12), and
forming a metal layer (15) using said second mask of said patterned resist layer (13) by an electrolytic plating method in which said conductive film (12) is used as one electrode.

2. Method for making a patterned metal layer in accordance with claim 1, wherein
the material of said metal layer is gold.

## Patentansprüche

1. Verfahren zum Herstellen einer gemusterten Metallschicht, umfassend die Schritte des:
Bildens eines leitenden Films (12) auf einem Substrat (11),
Bildens einer Widerstandsschicht (13), die aus einem organischen Material gebildet ist, auf dem leitenden Film (12),
Bildens eines anorganischen Films (14) auf der Widerstandsschicht (13),
wahlweisen Entfernens des anorganischen Films (14), um dadurch ein vorbestimmtes Muster zu erhalten,
wahlweisen Trockenätzens der Widerstandsschicht (13) unter Verwendung des anorganischen Films (14) des vorbestimmten Musters als eine erste Maske, um dadurch eine zweite Maske zu bilden, die Seitenwände hat, die rechtwinklig zu dem Substrat (11) und dem leitenden Film (12) verlaufen, und des
Bildens einer Metallschicht (15) unter Verwendung der zweiten Maske der gemusterten Widerstandsschicht (13) durch ein elektrolytisches Plattierungsverfahren, in welchem der leitende Film (12) als eine Elektrode verwendet wird.

2. Verfahren zum Herstellen einer gemusterten Metallschicht nach Anspruch 1, wobei
das Material der Metallschicht Gold ist.

## Revendications

1. Procédé pour fabriquer une couche métallique gravée comprenant les étapes consistant à :
former un film conducteur (12) sur un substrat (11),
former une couche de résine photosensible (13) constituée d'un matériau organique sur le film conducteur (12),
former un film inorganique (14) sur la couche de résine photosensible (13),
enlever sélectivement le film inorganique (14) maintenant de ce fait une gravure prédéterminée,
sécher sélectivement à sec la couche de résine photosensible (13) en utilisant le film inorganique (14) de la gravure prédéterminée comme un premier masque pour fabriquer de ce fait un second masque ayant des parois latérales perpendiculaires au substrat (11) et au film photoconducteur (12), et
former une couche métallique (15) en utilisant le second masque de la couche de résine photosensible gravée (13) par un procédé de dépot électrolytique dans lequel le film photoconducteur (12) est utilisé comme une électrode.

2. Procédé pour fabriquer une couche métallique gravée en conformité avec la revendication 1, dans lequel le matériau de la couche métallique est de l'or.
